# EUROPÄISCHE PATENTSCHRIFT

(11) **EP 1 495 492 B1**
(45) Veröffentlichungstag und Bekanntmachung des Hinweises auf die Patenterteilung: **02.06.2010**
(21) Anmeldenummer: 03729842.9
(22) Anmeldetag: 16.04.2003
(51) Int. Cl.: H01L 21/762, H01L 27/12, H01L 21/84

(54) **SUBSTRAT UND VERFAHREN ZUM HERSTELLEN EINES SUBSTRATS**
SUBSTRATE AND METHOD FOR PRODUCING A SUBSTRATE
SUBSTRAT ET PROCEDE DE PRODUCTION D'UN SUBSTRAT

(30) Priorität: 16.04.2002 DE 10216838; 22.05.2002 DE 10222679
(43) Veröffentlichungstag der Anmeldung: 12.01.2005
(73) Patentinhaber: Infineon Technologies AG, 85579 Neubiberg (DE)
(72) Erfinder: HOFMANN, Franz, 80995 München (DE); LUYKEN, Richard, Johannes, 81825 München (DE); RÖSNER, Wolfgang, 85521 Ottobrunn (DE); SPECHT, Michael, 80799 München (DE); STÄDELE, Martin, 85521 Ottobrunn (DE)
(74) Vertreter: Viering, Jentschura & Partner
(86) Internationale Anmeldenummer: PCT/DE2003/001281
(87) Internationale Veröffentlichungsnummer: WO 2003/088310

(56) Entgegenhaltungen:
- EP-A- 0 810 652
- US-A- 5 070 034
- US-A- 5 279 978
- US-A- 5 534 459
- PATENT ABSTRACTS OF JAPAN vol. 017, no. 160 (E-1342), 29. März 1993 (1993-03-29) -& JP 04 323851 A (NIPPONDENSO CO LTD), 13. November 1992 (1992-11-13)

## Beschreibung

Die Erfindung betrifft ein Substrat und ein Verfahren zum Herstellen eines Substrats.

Feldeffekttransistoren finden in vielen Gebieten der Elektronik Anwendung, insbesondere als Schalterelemente beziehungsweise als Speicherelemente eines integrierten Schaltkreises.

Insbesondere im Zuge der immer höher werdenden Anforderungen an Massenspeicher werden neue Transistortypen entwickelt und eingesetzt.

Um die Speicherdichte eines Halbleiterspeichers zu erhöhen, ist aus [1] bekannt, einen so genannten ONO-Feldeffekttransistor zu verwenden, um darin zwei Bit Information zu speichern. Bei dem aus [1] bekannten Feldeffekttransistor ist oberhalb des Kanal-Bereichs zwischen den beiden Source-/Drain-Bereichen eine ONO-Schichtenfolge vorgesehen, die eine Siliziumnitrid-Schicht zwischen zwei Siliziumoxid-Schichten aufweist. Mittels Einbringens von Ladungsträgern in die Siliziumnitrid-Schicht der ONO-Schichtenfolge können die elektrischen Transistoreigenschaften des ONO-Feldeffekttransistors charakteristisch beeinflusst werden. In die Grenzbereiche zwischen jeweils einem der beiden Source-/Drain-Bereiche und der ONO Schichtenfolge wird unter Verwendung des Tunneleffekts eine Ladungsmenge eingespeichert, mittels der die zu speichernde Information kodiert ist. Infolge der veränderten Transistoreigenschaften (z.B. Vorzeichen bzw. Stärke der Verschiebung des Wertes der Schwellenspannung) kann eine gespeicherte Information ausgelesen werden.

Aus [2] ist bekannt, Nanokristalle aus Germanium oder Silizium in einer Gate-isolierenden Schicht eines Feldeffekttransistors auszubilden und unter Verwendung des Tunneleffekts elektrische Ladungsträger in diese Nanokristalle dauerhaft einzubringen. Dadurch werden die Transistoreigenschaften des Feldeffekttransistors charakteristisch beeinflusst, wodurch die in dem Feldeffekttransistor gespeicherte Information, die mittels der in den Nanokristallen eingebrachten Ladungsmenge kodiert ist, als veränderte Transistoreigenschaften ausgelesen werden können.

Ein wichtiges Teilgebiet der Siliziummikroelektronik ist die sogenannte SOI Technologie ("Silicon-on-Insulator"). Grundlagen der SOI-Technologie sind beispielsweise in [3] beschrieben. Für die SOI-Technologie wird ein SOI-Substrat benötigt, das aus einem Schichtstapel Silizium-Siliziumoxid-Silizium aufgebaut ist, wobei die beiden Silizium-Schichten, welche die Siliziumoxid-Schicht beidseitig umgeben, nach Möglichkeit einkristallin sein sollten.

Ein zentrales Problem konventioneller integrierter Schaltkreise ist die Verschlechterung der elektrischen Eigenschaften von MOS-Transistoren bei zunehmender Strukturfeinheit aufgrund von Effekten wie dem Punch-Through-Effekt und dem Latch-Up-Effekts. Bei Verwendung der SOI-Technologie sind diese Probleme abgemildert.

Allerdings bestehen technologische Probleme einerseits in der Erzeugung einer isolierten einkristallinen Schicht auf einer Siliziumoxid-Schicht und andererseits in der Integration dieses Prozessschrittes in einen Gesamtprozess bei der Herstellung eines integrierten Schaltkreises.

Ein Verfahren zum Herstellen einer SOI-Schichtenfolge ist beispielsweise in [4] beschrieben. Gemäß dem dort beschriebenen, von der Firma Soitec entwickelten Smart-Cut^{™} Verfahren werden Wasserstoff-Ionen in ein oxidiertes Silizium-Substrat implantiert und bilden eine vergrabene, mechanisch geschwächte Ablöseschicht aus. Unter Verwendung eines Wafer-Bonding-Verfahrens kann die Siliziumoxid-Schicht auf einem weiteren Silizium-Substrat befestigt werden. Dadurch wird eine SOI Schichtenfolge erhalten. Nach einem geeigneten Temper-Verfahrensschritt kann die oberhalb der Ablöseschicht angeordnete SOI-Schichtenfolge aus einer dünnen Silizium-Schicht, einer Siliziumoxid-Schicht und dem Silizium-Substrat an der Oberfläche von dem Träger-Wafer abgelöst werden.

Ein wichtiger Aspekt beim Ausbilden eines Feldeffekttransistors eines integrierten Schaltkreises ist das Einstellen der Schwellwertspannung des Transistors. Bei herkömmlichen Transistorgenerationen wird dies mittels Einstellens der Dotierung des Kanal-Bereichs und mittels Einstellens der Gate-Austrittsarbeit, das heißt mittels Auswählens des Materials für den Gate-Bereich, durchgeführt. Ferner können sogenannte Pocket-Bereiche, das heißt speziell dotierte Bereiche in dem Kanal-Bereich, ausgebildet werden, um die Schwellwertspannung eines herkömmlichen Transistors zu beeinflussen.

Allerdings kann das Material für den Gate-Bereich aus technologischen Gründen vorgegeben sein bzw. die freie Materialwahl eingeschränkt sein, so dass die Materialwahl als Parameter zum Einstellen der Schwellwertspannung eines Feldeffekttransistors entfallen kann. Ferner ist bei der SOI-Technologie üblicherweise eine sehr dünne Silizium-Schicht oberhalb der Siliziumoxid-Schicht vorgesehen, so dass anschaulich kein ausreichendes Volumen zum Ausbilden von Pocket-Bereichen bei der Dünnschicht-SOI-Technologie verbleibt. Daher entfällt auch dieser Parameter zum Einstellen der Schwellwertspannung bei der SOI-Technologie.

Ferner hat das Einstellen der Schwellenspannung mittels Dotierens des Kanal-Bereichs den Nachteil, dass aufgrund von technologisch unvermeidbaren Inhomogenitätsschwankungen der Ladungsträgerdichte in dem Kanal-Bereich unterschiedlicher Feldeffekttransistoren eines Schaltkreises auch die Schwellwertspannung unerwünschterweise einer Schwankung unterworfen sein kann. Ferner führt das Dotieren des Kanal-Bereichs zu einer Erhöhung der Anzahl von Streuzentren für Ladungsträger und hat daher eine unerwünschte Erhöhung des ohmschen Widerstandes zur Folge.

Daher verbleibt bei der technologisch interessanten Dünnschicht-SOI Technologie allenfalls das Einstellen der Austrittsarbeit des Gate-Materials als Parameter zum Einstellen der Schwellwertspannung. Jedoch kann die freie Auswahl eines Materials des Gate-Bereichs aus technologischen Gründen eingeschränkt sein.

Es ist festzustellen, dass in Single-Gate-SOI-Transistoren oder Double-Gate-SOI-Transistoren häufig auf eine Kanal-Dotierung verzichtet wird, um einen geringen ohmschen Widerstand und daher einen hohen On-Strom zu erreichen, und um Schwankungen der Schwellwertspannung infolge einer Fluktuation der Dotierstoffkonzentration zu vermeiden. Dies hat jedoch häufig zur Folge, dass ein Transistor im Off-Zustand nur dann ausreichend sicher sperrt, wenn bei einem n-Kanal-Transistor ein Gate-Material mit einer Austrittsarbeit verwendet wird, die mindestens so hoch ist wie etwa die sogenannte "Midgap"-Austrittsarbeit, und wenn der Kanal-Bereich vorzugsweise vollständig an freien Ladungsträgern verarmt ("fully depleted") ist.

Mit zunehmender Strukturverfeinerung von MOS-Feldeffekttransistoren kommt es bei deren Betrieb zum Verstärken von negativen Effekten wie z.B. Schwellenspannungsabfall, den Punch-Through-Effekt, den Latchup-Effekt sowie zu den in Relation zur reziproken Transistorgröße überproportional wachsenden parasitären Kapazitäten zwischen Source/Drain-Gebieten und dem Substrat. Für die obig beschriebenen Probleme stellt die SOI-Technik (SOI = Silicon on Isolator) eine Lösung dar. Gemäß dieser Technik wird jedes Bauelement in einer dünnen, von seiner Umgebung elektrisch isolierten Siliziuminsel hergestellt. Infolge der fehlenden Verbindung zwischen den Siliziuminseln kann kein Latchup-Effekt auftreten. Weiterhin mildern sich Kurzkanaleffekte, da die aktive Funktion der Transistoren auf einen dünnen Siliziumfilm beschränkt ist.

Bisher werden hauptsächlich sogenannte Dickschicht-SOI-Substrate verwendet. Diese weisen eine relativ dicke Schicht von Silizium auf, welche nach deren Erzeugung mittels Dotierens in einen Bereich umgewandelt wird, welcher teilweise an elektrischen Ladungsträgern verarmt (PD-Bereich = partially depleted-Bereich) ist. Diese PD-SOI-Substrate werden zum Beispiel in Analoggeräten, in Photodioden-Arrays und schnellen bipolaren integrierten Schaltkreisen (ICs) verwendet.

Dünnschicht-SOI-Substrate, welche eine dünne Schicht von Silizium aufweisen, welche Schicht nach deren Erzeugung mittels schwachen Dotierens in einen Bereich umgewandelt wird, welcher vollständig an elektrischen Ladungsträgern verarmt (FD-Bereich = fully depleted-Bereich) ist, werden zur Zeit nur in geringen Maße verwendet. Diese FD-SOI-Transistoren weisen eine hohe Geschwindigkeit sowie einen geringen Stromverbrauch auf.

In Zukunft wird, wegen derer hoher Geschwindigkeit und dem geringen Stromverbrauch, mit einem steigenden Anteil von FD-SOI-Substraten gerechnet. Mit dem steigenden Anteil der FD-SOI-Substrate wird es auch zu einem Bedarf an Substraten kommen, welche auf einem Substrat sowohl Dünnschicht-SOI-Bereiche als auch Dickschicht-SOI-Bereiche (Mischsubstrate) enthalten, um die Vorteile von PD-Bereichen bzw. FD-Bereichen auf einem gemeinsamen Substrat nutzen zu können. Die Dicke der Siliziumschicht bzw. der Grad der Verarmung an elektrischen Ladungsträgern bestimmt die Einsatzspannung des Transistors. Für schnelle Logikelemente werden z.B. Transistoren mit unterschiedlichen Einsatzspannungen in einem Schaltkreis integriert. Zum Beispiel findet man bei einem embedded Flash Element Transistoren mit ca. 6 unterschiedlichen Einsatzspannungen.

Die Einsatzspannung von Transistoren, welche auf einem FD-SOI-Substrat aufgebracht sind, lässt sich vorzugsweise über die Austrittsarbeit des Gatematerials des Transistors einstellen. Bei einem Transistor, welcher auf einem PD-SOI-Substrat aufgebracht ist, kann man die Einsatzspannung wie bei einem Bulk-Transistor über eine Kanalimplantation definieren. Als Bulk-Transistor wird in diesem Zusammenhang ein Transistor bezeichnet, bei dem der Transistor mittels Dotierens im niedrig dotierten Gebiet der jeweils komplementären Dotierung aufgebaut wird. Z.B. wird für die Realisierung eines NMOS-Transistors ein p-Substrat verwendet, in welches hinein der NMOS-Transistor unmittelbar realisiert wird.

Bisher werden solche Mischsubstrate erzeugt, indem ein PD-SOI-Substrat an den Stellen, welche einen FD-Bereich bilden sollen, bis auf eine verbleibende Dicke, welche für ein FD-SOI-Substrat vorgesehen ist, gedünnt wird. Das Dünnen lässt sich mittels einer lokalen Siliziums-Ätzung der PD-SOI-Schicht erreichen. Ein weiteres Verfahren zum Herstellen einer FD-Schicht auf einem PD-SOI-Substrat ist eine lokale Oxidation der PD-SOI-Schicht mit anschließendem Entfernen des gebildeten Siliziumoxids.

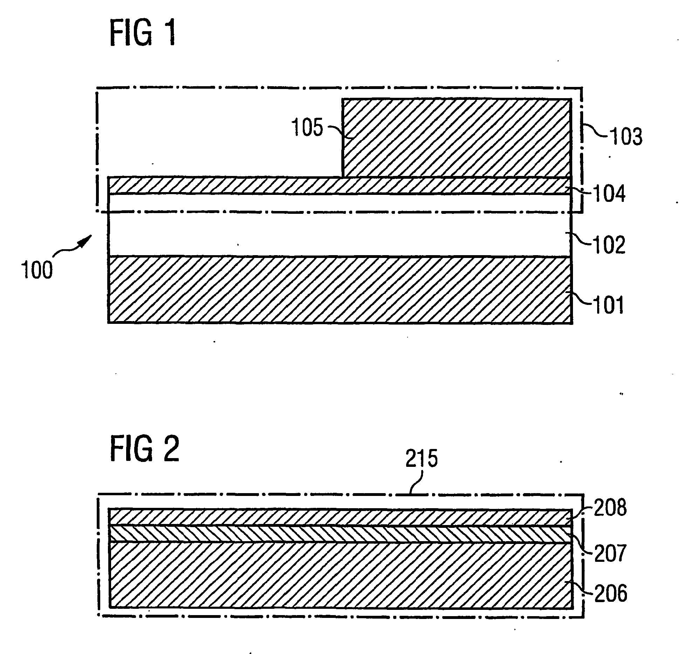

Ferner kann ein Mischsubstrat auch hergestellt werden, indem auf eine FD-SOI-Schicht mittels selektiver Epitaxie in einem Bereich der FD-SOI-Schicht eine weitere Siliziumschicht ausgebildet wird, wodurch ein zweiter Bereich, in welchem die Siliziumschicht eine größere Dicke (PD-SOI-Bereich) als im FD-SOI-Bereich aufweist, gebildet wird.In Figur 1 ist ein Mischsubstrat abgebildet, welches gemäß einem Verfahren gemäß dem Stand der Technik erzeugt wurde.

Figur 1 zeigt ein SOI-Substrat 100 gemäß dem Stand der Technik, welches auf einem Siliziumträgersubstrat 101 eine Siliziumoxidschicht 102 und Bereiche einer Siliziumhalbleiterschicht 103 aufweist, welche verschiedene Dicken aufweisen. Ein erster Bereich 104 der Siliziumhalbleiterschicht 103 weist eine geringere Dicke von typischerweise etwa 20 nm auf und ist als ein Bereich ausgebildet, welcher vollständig an Ladungsträgern verarmt ist. Ein zweiter Bereich 105 der Siliziumhalbleiterschicht 103 weist eine größere Dicke von typischerweise etwa 100 nm auf und ist als Bereich ausgebildet, welcher teilweise an Ladungsträgern verarmt ist. Im Allgemeinen werden die beiden Bereiche 104, 105 der Halbleiterschicht mittels Abscheidens einer dicken Siliziumhalbleiterschicht ausgebildet, welche nachfolgend in dem Bereich, welcher später in den ersten Bereich 104 umgebildet werden soll, welcher vollständig an Ladungsträgern verarmt ist, zurückgeätzt werden. Durch dieses Herstellungsverfahren eines Mischsubstrats gemäß dem Stand der Technik ergeben sich durch die Bereiche verschiedener Dicke 104 und 105 Probleme bei der weiteren Bearbeitung des Mischsubstrats.

Die durch die verschiedenen Dicken der Siliziumschichten verursachten Stufen stellen ein Problem bei einer nachfolgenden Gate-Verdrahtung über die Grenzen der verschiedenen FD-Bereiche bzw. PD-Bereiche hinweg dar.

Ein weiteres Problem ist, dass es beim nachfolgenden lithographischen Belichten der Oberfläche durch die begrenzte Fokustiefe eines zum Belichten verwendeten Steppers zu Problemen bei der Belichtung über die vorhandenen Grenzen zwischen jeweils einem PD-Bereich und einem FD-Bereich hinweg kommen kann.

Ferner weisen die Verfahren, bei denen die Halbleiterschicht in Bereichen zurückgeätzt wird oder bei denen die Halbleiterschicht oxidiert wird, das Problem auf, dass eine exakte Kontrolle der Siliziumdicken, welche mittels des Ätzens oder Oxidierens erzeugt werden, schwierig ist.
[5] offenbart das Herstellen eines Mehrfachschicht-Substrats, in dem eine Dünnschicht-Halbleiter-Aktivschicht mit einer gleichmäßigen Dicke ausgebildet werden kann und die Arbeitseffektivität verbessert werden kann.
[6] offenbart das Herstellen einer Halbleitervorrichtung, bei dem zum Verringern von Produktionskosten und zum Vereinfachen der Qualitätskontrolle einfache Formationsschritte verwendet werden.
[7] offenbart das Herstellen einer Halblentervorrichtung auf SOI Schichten unterschiedlicher Dicke
[8] offenbart das Herstellen einer Holbleitervorrichtung auf SOI Schichten unterschieldliches Dicke in an Ladungsträgern teilweise oder vollständig verarmten gebieten.

Der Erfindung liegt das Problem zugrunde, ein Substrat bereitzustellen, bei dem die oben beschriebenen Nachteile beim Verdrahten bzw. beim Belichten des Substrats vermieden sind.

Das Problem wird durch ein Substrat sowie durch ein Verfahren zum Herstellen eines Substrats mit den Merkmalen gemäß den unabhängigen Patentansprüchen 1 und 4 gelöst. Ein Substrat weist eine Trägerschicht auf. Auf der Trägerschicht befindet sich eine Isolatorschicht, welche mindestens zwei Bereiche mit jeweils unterschiedlicher Dicke aufweist, so dass eine gestufte Oberfläche der Isolatorschicht ausgebildet ist. Auf der gestuften Oberfläche der Isolatorschicht befindet sich eine Halbleiterschicht, welche Halbleiterschicht eine planare Oberfläche aufweist, wobei die planare Oberfläche der Halbleiterschicht die Oberfläche ist, welche der gestuften Oberfläche der Isolatorschicht entgegengesetzt ist.

Ein erfindungsgemäßes Verfahren zum Herstellen von einem Substrat mit Bereichen von Halbleiterschichten, welche verschiedene Dicken aufweisen, weist folgende Schritte auf. Auf einer ersten Trägerschicht wird eine Isolatorschicht aufgebracht. Die Isolatorschicht weist Bereiche verschiedener Dicken auf, so dass eine gestufte Oberfläche der Isolatorschicht ausgebildet wird. Als weiterer Schritt wird eine Halbleiterschicht auf der gestuften Oberfläche der Isolatorschicht aufgebracht, so dass eine planare Oberfläche der Halbleiterschicht gebildet wird, wobei als planare Oberfläche die Fläche ausgebildet wird, welche der gestuften Oberfläche der Isolatorschicht entgegengesetzt ist.

Das erfindungsgemäße Substrat weist Bereiche eines Halbleiters auf, in denen die Halbleiterbereiche verschiedene Dicken aufweisen. Das Substrat weist gleichzeitig eine ebene Oberfläche der Halbleiterschicht auf. Insbesondere aufgrund der ebenen Oberfläche der Halbleiterschicht werden die oben beschriebenen Nachteile eines Mischsubstrates gemäß dem Stand der Technik vermieden.

Aufgrund der planaren Oberfläche kommt es bei einer Verdrahtung über Bereichsgrenzen zwischen Bereichen, welche verschiedene Dicken von Halbleiterschichten aufweisen, hinweg nicht zu den Problemen wie bei einer gestuften Oberfläche des Substrats.

Die planare Oberfläche des Substrats bewirkt, dass die begrenzte Fokustiefe, welche ein zum Belichten verwendeter Stepper aufweist, bei einem lithographischen Belichten des Substrats über Bereichsgrenzen zwischen Bereichen, welche verschiedene Dicken von Halbleiterschichten aufweisen, keine Probleme mehr verursacht.

Bevorzugte Ausgestaltungen der Erfindung ergeben sich aus den abhängigen Ansprüchen.

Gemäß einer bevorzugten Ausführungsform wird die Halbleiterschicht aus Silizium und/oder die Isolatorschicht aus Siliziumoxid gebildet.

In einer weiteren Ausführungsform sind die Bereiche der Halbleiterschicht zweier verschiedener Dicken als Bereiche ausgebildet, welche teilweise an Ladungsträgern verarmt sind bzw. vollständig an Ladungsträgern verarmt sind.

In einer anderen Ausführungsform besteht das Substrat aus zwei Teilsubstraten, welche mittels Bondens miteinander gekuppelt werden.

Ein bevorzugtes Ausführungsbeispiel des Verfahrens zum Herstellen eines erfindungsgemäßen Substrats weist dabei folgende Teilschritte auf. Ein Teilschritt zum Ausbilden der Halbleiterteilschicht ist ein Ausbilden einer dünnen ersten Halbleiterteilschicht auf einer Hilfsträgerschicht eines ersten Teilsubstrats. Das Ausbilden der Isolatorschicht weist den Teilschritt des Abscheidens einer Schutzschicht, welche als Maskierungsschicht dient, aus einem Isolatormaterial in zumindest einem Bereich der dünnen ersten Halbleiterteilschicht auf. Das Ausbilden der Halbleiterschicht weist ferner den Teilschritt des Ausbildens einer zweiten Halbleiterteilschicht in den Bereichen der dünnen ersten Halbleiterteilschicht auf, welche nicht durch die Maskierungsschicht aus dem Isolatormaterial bedeckt sind. Die Ausbildung der Isolatorschicht weist ferner den Teilschritt eines Ausbildens einer ersten Isolatorteilschicht auf der gesamten Teilsubstratoberfläche auf. Anschließend wird die Oberfläche der ersten Isolatorteilschicht planarisiert. Ein weiterer Teilschritt ist das Bonden eines zweiten Teilsubstrats, welches auf einer Trägerschicht eine zweite Isolatorteilschicht aufweist, auf die planarisierte Oberfläche der ersten Isolatorteilschicht. Danach wird die Hilfsträgerschicht entfernt.

Vorzugsweise wird die erste Isolatorteilschicht mittels chemisch-mechanischen Polierens planarisiert.

Gemäß einer anderen Ausführungsform wird vor dem Aufbringen der dünnen ersten Halbleiterteilschicht eine Schicht aus porösen Silizium auf der Hilfsträgerschicht erzeugt, welches poröse Silizium zum Entfernen der Hilfsträgerschicht mittels Ätzens mittels eines Wasserstrahls entfernt wird.

Gemäß einer anderen Ausführungsform weist das Verfahren nach dem Entfernen der Hilfsträgerschicht den Schritt einer H₂-Temperung (Wasserstoff-Temperung) des Substrats auf.

Vorzugsweise weisen die Trägerschicht, die Hilfsträgerschicht, die dünne erste Halbleiterteilschicht und die zweite Halbleiterschicht im Wesentlichen Silizium und/oder die erste Isolatorteilschicht, die zweite Isolatorteilschicht und die Schutzschicht im Wesentlichen Siliziumoxid auf.

Vorzugsweise werden die dünne erste Halbleiterteilschicht und/oder die zweite Halbleiterteilschicht mittels Epitaxie und/oder selektiver Epitaxie ausgebildet.

Vorzugsweise werden aus den Bereichen einer Halbleiterschicht, welche aus der dünnen ersten Halbleiterteilschicht und der zweiten Halbleiterteilschicht gebildet wird, welche Bereiche eine größere Dicke aufweisen, mittels Dotierens Bereiche erzeugt, welche teilweise an Ladungsträgern verarmt sind. Ferner wird aus dem Bereich der Halbleiterschicht, welcher eine kleinere Dicke aufweist, mittels schwachen Dotierens ein Bereich erzeugt, welcher vollständig an Ladungsträgern verarmt ist.

Mittels der dargelegten Ausführungsbeispiele wird ein Substrat geschaffen, welches Bereiche einer Halbleiterschicht von verschiedener Dicke aufweist, wobei die Oberfläche der Halbleiterschicht als eine planare Oberfläche ausgebildet ist. Diese planare Oberfläche wird in dem erfindungsgemäßen Verfahren mittels einfacher Prozessschritte erlangt.

Durch das Verwenden von Epitaxie zum Aufbringen der ersten Halbleiterteilschicht und der zweiten Halbleiterteilschicht, lässt sich die Dicke der ersten Halbleiterteilschicht und der zweiten Halbleiterteilschicht exakt einstellen.

Da auf einem Substrat mittels des Verfahrens Bereiche ausgebildet werden, welche teilweise an Ladungsträgern verarmt sind (PD-Bereiche) bzw. Bereiche ausgebildet werden, welche vollständig an Ladungsträgern verarmt (FD-Bereiche) sind, lassen sich in einfacher und somit kostengünstiger Weise verschiedene Schaltspannungen von Transistoren verwirklichen, welche Transistoren auf dem erfindungsgemäßen Substrat ausgebildet werden. Dies erleichtert z.B. das Herstellen von Logikschaltungen, bei denen Transistoren verschiedener Schaltspannungen verwendet werden.

Gemäß einem alternativen Aspekt der Erfindung sind ein Feldeffekttransistor, eine Feldeffekttransistor-Anordnung, ein Verfahren zum Justieren einer elektrischen Transistoreigenschaft eines Feldeffekttransistors und ein Verfahren zum Herstellen eines Feldeffekttransistors mit den im Weiteren beschriebenen Merkmalen bereitgestellt.

Dadurch ist eine Möglichkeit geschaffen, die Schwellwertspannung oder eine andere elektrische Transistoreigenschaft eines Feldeffekttransistors ausreichend genau und mit verringertem Aufwand flexibel einstellen zu können.

Der erfindungsgemäße Feldeffekttransistor hat eine Ladungsspeicherschicht unterhalb des Kanal-Bereichs, die derart angeordnet ist, dass mittels Einbringens von elektrischen Ladungsträgern in die Ladungsspeicherschicht eine elektrische Transistoreigenschaft des Feldeffekttransistors justierbar ist.

Die erfindungsgemäße Feldeffekttransistor-Anordnung weist eine Mehrzahl von in und/oder auf einem gemeinsamen Substrat ausgebildeten Feldeffekttransistoren mit den oben genannten Merkmalen auf.

Gemäß dem erfindungsgemäßen Verfahren zum Justieren einer elektrischen Transistoreigenschaft eines Feldeffekttransistors mit einer Ladungsspeicherschicht unterhalb des Kanal-Bereichs wird die elektrische Transistoreigenschaft des Feldeffekttransistors justiert, indem elektrische Ladungsträger in die Ladungsspeicherschicht eingebracht werden.

Ferner ist erfindungsgemäß ein Verfahren zum Herstellen eines Feldeffekttransistors bereitgestellt, bei dem eine Ladungsspeicherschicht unterhalb des Kanal-Bereichs derart angeordnet wird, dass mittels Einbringens von elektrischen Ladungsträgern in die Ladungsspeicherschicht eine elektrische Transistoreigenschaft des Feldeffekttransistors justierbar ist.

Eine Grundidee des beschriebenen Aspekts der Erfindung besteht darin, unterhalb des Kanal-Bereichs eine Ladungsspeicherschicht vorzusehen, vorzugsweise von einer beidseitigen elektrisch isolierenden (dielektrischen) Schicht von der Umgebung geschützt, wobei mittels Einbringens von elektrischen Ladungsträgern in die Ladungsspeicherschicht die Transistoreigenschaften, insbesondere die Schwellenspannung des Transistors, sehr genau justiert werden können. Dadurch ist, wenn ein Einstellen der Schwellwertspannung mittels Auswählens der Kanal-Dotierung bzw. mittels Auswählens des Materials des Gate-Bereichs zum Beispiel aus technologischen Gründen oder zum Vermeiden eines hochohmigen Kanal-Bereichs nicht möglich ist, eine weitere Möglichkeit zum Einstellen der Schwellwertspannung eines Feldeffekttransistors bereitgestellt. Die Ladungsspeicherschicht kann beispielsweise als elektrisch leitfähige Schicht (z.B. dotiertes Polysilizium), als ONO-Schichtenfolge oder als Schicht mit Nanokristallen unterhalb des Kanal-Bereichs realisiert sein.

Der beschriebene Aspekt Erfindung weist insbesondere den Vorteil auf, dass eine Möglichkeit geschaffen ist, insbesondere in einem undotierten Kanal-Bereich eines SOI-Feldeffekttransistors die Schwellwertspannung einzustellen. Ferner ist eine Feinjustierung möglich, die insbesondere auf eine vorgegebene Gate-Austrittsarbeit abstimmbar ist, so dass es ermöglicht ist, unterschiedliche Gate-Materialien zu verwenden.

Bei der erfindungsgemäßen Feldeffekttransistor-Anordnung kann eine Kompartimentierung der Ladungsspeicherschicht derart vorgenommen werden, dass ein unterhalb eines bestimmten Feldeffekttransistors der Feldeffekttransistor-Anordnung angeordneter Bereich der Ladungsspeicherschicht unabhängig von anderen Bereichen der Ladungsspeicherschicht mit elektrischen Ladungsträgern belegt werden kann.

Dadurch ist es ermöglicht, bei einer Transistor-Anordnung unterschiedliche Transistoren mit unterschiedlichen Schwellwertspannungen auszugestalten.

Dies ist ein Vorteil insbesondere im Vergleich zu einer einfachen Kontaktierung des Substrats, mit der eine Schwellwertjustierung nicht in der Weise möglich ist, dass für unterschiedliche Transistoren unterschiedliche Schwellwertspannungen einstellbar sind.

Unter einer Kompartimentierung wird insbesondere verstanden, die Ladungsspeicherschicht in mehrere voneinander elektrisch entkoppelte oder entkoppelbare Teilbereiche aufzuteilen, wobei jeder Teilbereich einem Feldeffekttransistor der Feldeffekttransistor-Anordnung zugeordnet ist. Mittels selektiven Injizierens einer jeweils vorgebbaren Menge von elektrischen Ladungsträgern in die einzelnen, kompartimentierten Teilbereiche kann für jeden Transistor individuell eine Schwellenspannung eingestellt werden.

Ferner ist es erfindungsgemäß möglich, die minimale Dicke des SOI-Materials mit einem völlig verarmten Kanal-Bereich zu erhöhen, beispielsweise mindestens um einen Faktor zwei.

Bevorzugte Weiterbildungen des beschriebenen Aspekts der Erfindung ergeben sich aus den abhängigen Ansprüchen.

Vorzugsweise kann die Ladungsspeicherschicht eine ONO-Schichtenfolge (Oxid-Nitrid-Oxid), eine Nanokristall-Struktur oder eine elektrisch leitfähige Schicht (insbesondere eine Schicht aus einem "floatenden" elektrisch leitfähigen Material, beispielsweise dotiertes Polysilizium oder Metall) sein.

Der Feldeffekttransistor der Erfindung kann derart eingerichtet sein, dass elektrische Ladungsträger in die Ladungsspeicherschicht mittels Bestrahlens des Feldeffekttransistors mit einem Elektronenstrahl, mittels Fowler-Nordheim-Tunnelns zwischen einem Source-/Drain-Bereich und der Ladungsspeicherschicht oder mittels zeitweisen Koppelns der Ladungsspeicherschicht mit einer Quelle elektrischer Ladungsträger über einen elektrisch leitfähigen Anschluss einbringbar sind.

Das Einbringen elektrischer Ladungsträger in die Ladungsspeicherschicht mittels Bestrahlens des Feldeffekttransistors mit einem Elektronenstrahl kann beispielsweise bei einem Elektronenstrahl-Lithographie-Verfahrensschritt erfolgen, wobei ein Elektronenstrahl auf ein Substrat mit darin eingebetteter Ladungsspeicherschicht gerichtet werden kann, wodurch Elektronen in der Ladungsspeicherschicht dauerhaft gespeichert werden.

Ferner ist es möglich, mittels Anlegens einer geeigneten Spannung an die Anschlüsse des Feldeffekttransistors Fowler-Nordheim-Tunnelprozesse zwischen einem Source-/Drain-Bereich und der Ladungsspeicherschicht zu bewirken mit der Folge, dass nicht kompensierte elektrische Ladungsträger in der Ladungsspeicherschicht zurückbleiben, wodurch die Transistoreigenschaften des Feldeffekttransistors eingestellt sind.

Auch kann die Ladungsspeicherschicht, insbesondere ausgestaltet als elektrisch leitfähige Schicht, mit einem elektrisch leitfähigen Anschluss gekoppelt sein, über den die Ladungsspeicherschicht mit einer elektrischen Ladungsträgerquelle, insbesondere einer Spannungsversorgung, koppelbar ist, sodass über die Spannungsquelle elektrische Ladungsträger in die Ladungsspeicherschicht injizierbar sind.

Vorzugsweise ist der Kanal-Bereich von einer Dotierung frei, d.h. der Kanal-Bereich ist nicht mit von extern eingebrachten Ladungsträgern versehen. Dadurch sind unerwünschte Effekte aufgrund einer Dotierstoffkonzentrationsschwankung vermieden und der On-Strom aufgrund der erhöhten Mobilität verstärkt.

Der Feldeffekttransistor kann als SOI-Feldeffekttransistor ("Silicon-on-Insulator") ausgestaltet sein.

Die einstellbare elektrische Transistoreigenschaft des Feldeffekttransistors ist vorzugsweise die Schwellenspannung, kann jedoch auch die Leckstrom-Charakteristik, der MaximalStrom und/oder eine Transistor-Kennlinie sein.

Vorzugsweise ist die als elektrisch leitfähige Schicht ausgestaltete Ladungsspeicherschicht von einer elektrisch isolierenden Hüllschicht umgeben. Mittels einer solchen Hüllschicht ist es ermöglicht, dass die elektrisch leitfähige Schicht von der Umgebung elektrisch isoliert ist, sodass die elektrischen Ladungsträger vor einem Abfließen aus der Ladungsspeicherschicht geschützt sind. Die Dicke einer solchen Schicht, die vorzugsweise als Siliziumoxid-Schicht ausgestaltet ist, beträgt vorzugsweise mindestens ungefähr 10nm, wodurch sichergestellt ist, dass eine dauerhafte Schwellwertajustierung ermöglicht ist, vorzugsweise für eine Haltezeit von mindestens zehn Jahren.

Die elektrisch leitfähige Schicht ist vorzugsweise aus Polysilizium-Material hergestellt.

Im Weiteren wird die erfindungsgemäße Feldeffekttransistor-Anordnung, die erfindungsgemäße Feldeffekttransistoren aufweist, näher beschrieben. Ausgestaltungen des Feldeffekttransistors gelten auch für die Feldeffekttransistor-Anordnung.

Bei der Feldeffekttransistor-Anordnung ist vorzugsweise eine gemeinsame Ladungsspeicherschicht aller oder eines Teils der Feldeffekttransistoren derart kompartimentiert, dass die elektrische Transistoreigenschaft jedes Feldeffekttransistors unabhängig von den übrigen Feldeffekttransistoren einstellbar ist.

Unter dem Begriff Kompartimentierung wird hier insbesondere verstanden, dass die Ladungsspeicherschicht in mehrere Teilbereiche aufgeteilt ist, die anschaulich voneinander unabhängig mit elektrischen Ladungsträgern belegt werden können. Dies kann beispielsweise realisiert sein, indem die Ladungsträger unter Verwendung eines Elektronenstrahls in die Ladungsspeicherschicht eingebracht werden, wobei ein Teilbereich eines Substrats beim Anlegen des Elektronenstrahls mit einer solchen Schutzschicht bedeckt sein kann, dass ein Eindringen des Elektronenstrahls in den darunter gelegenen Bereich der Ladungsspeicherschicht vermieden ist.

Das Kompartimentieren kann für den Fall des Ausgestaltens der Ladungsspeicherschicht als elektrisch leitfähige Schicht derart realisiert sein, dass unterschiedliche Bereiche der elektrisch leitfähigen Schicht voneinander elektrisch entkoppelt oder entkoppelbar sind und mittels externer Anschlüsse voneinander separat mit Ladungsträgern belegbar sind.

Wird beispielsweise eine ONO-Schichtenfolge unter Verwendung des Fowler-Nordheim Tunnels zwischen einem Source-/Drain-Bereich und der Ladungsspeicherschicht beschrieben, so besteht die Kompartimentierung vorzugsweise darin, dass jeweils ein bestimmter Feldeffekttransistor ausgewählt wird und an dessen Source-/Drain-Bereich eine solche Spannung angelegt wird, dass lokal zwischen diesem Source-/Drain-Bereich und dem darunter liegenden Bereich der ONO-Schichtenfolge ein Tunnelstrom von Ladungsträgern ermöglicht ist. Mit anderen Worten kann dann jeder der Bereiche der ONO-Schichtenfolge unterhalb eines jeweiligen Feldeffekttransistors der erfindungsgemäßen Feldeffekttransistor-Anordnung unabhängig von den anderen Feldeffekttransistoren beschrieben werden, da der Tunnelstrom jeweils im Wesentlichen auf den Bereich eines auswählbaren Feldeffekttransistors in dem Substrat beschränkt ist.

Im Weiteren wird das erfindungsgemäße Verfahren zum Justieren einer elektrischen Transistoreigenschaft eines Feldeffekttransistors näher beschrieben. Ausgestaltungen des Feldeffekttransistors beziehungsweise der Feldeffekttransistor-Anordnung gelten auch für das Verfahren zum Justieren einer elektrischen Transistoreigenschaft.

Gemäß dem Verfahren zum Justieren einer elektrischen Transistoreigenschaft eines Feldeffekttransistors werden vorzugsweise elektrische Ladungsträger in die Ladungsspeicherschicht eingebracht, indem der Feldeffekttransistor mit einem Elektronenstrahl bestrahlt wird, indem Fowler-Nordheim Tunneln zwischen einem Source-/Drain-Bereich und der Ladungsspeicherschicht erzeugt wird, oder indem die Ladungsspeicherschicht mit einer elektrischen Ladungsträgerquelle über einen elektrisch leitfähigen Anschluss gekoppelt wird.

Im Weiteren wird das erfindungsgemäße Verfahren zum Herstellen eines Feldeffekttransistors beschrieben. Ausgestaltungen des Feldeffekttransistors beziehungsweise der Feldeffekttransistor-Anordnung gelten auch für das Verfahren zum Herstellen eines Feldeffekttransistors.

Gemäß dem Herstellungsverfahren kann eine Nanokristall-Struktur als Ladungsspeicherschicht ausgebildet werden, indem eine Siliziumoxid-Schicht (z.B. eine Siliziumoxid-Schicht) in einem Oberflächenbereich eines Silizium-Substrats ausgebildet wird und indem in die Siliziumoxid-Schicht Silizium derart eingebracht wird, dass dadurch in der Siliziumoxid-Schicht eine Nanokristall-Struktur ausgebildet wird.

Eine ONO-Schichtenfolge als Ladungsspeicherschicht kann ausgebildet werden, indem eine Siliziumoxid-Schicht in einem Oberflächenbereich eines Silizium-Substrats ausgebildet wird, indem in die Siliziumoxid-Schicht Stickstoff derart eingebracht wird, dass dadurch in einem Oberflächenbereich der Siliziumoxid-Schicht eine Siliziumnitrid-Schicht ausgebildet wird, und indem in die Siliziumnitrid-Schicht Sauerstoff derart eingebracht wird, dass dadurch in einem Oberflächenbereich der Siliziumnitrid-Schicht eine weitere Siliziumoxid-Schicht ausgebildet wird.

Eine elektrisch leitfähige Schicht als Ladungsspeicherschicht kann ausgebildet werden, indem auf einem Silizium-Substrat eine Polysilizium-Schicht vorzugsweise zwischen zwei elektrisch isolierenden Schichten ausgebildet wird.

Ferner kann gemäß dem beschriebenen Verfahren in dem Silizium-Substrat unterhalb der Ladungsspeicherschicht eine Ablöseschicht ausgebildet werden, indem ein weiteres Silizium-Substrat an der Ladungsspeicherschicht befestigt wird, indem das Material unterhalb der Ablöseschicht entfernt wird und indem ein Feldeffekttransistor in bzw. auf einer Schicht zwischen Ablöseschicht und Ladungsspeicherschicht ausgebildet wird.

Zusammenfassend ist festzustellen, dass anschaulich das elektrische Feld im Kanal-Bereich des erfindungsgemäßen Feldeffekttransistors mittels Einbringens von Ladungsträgern in eine unterhalb des Kanal-Bereichs angeordnete Ladungsspeicherschicht modifiziert wird, was eine charakteristische Beeinflussung der Schwellwertspannung zur Folge hat.

Das Einbringen von elektrischen Ladungsträgern in die Ladungsspeicherschicht unterhalb des Kanal-Bereichs kann beispielsweise nach Beendigung des Herstellungs-Verfahrens des Feldeffekttransistors mittels vorübergehenden Aufbringens einer elektrisch leitfähigen Schicht auf den SOI-Wafer und anschließendem Fowler-Nordheim Tunneln erfolgen. Eine Kompartimentierung kann beispielsweise derart erfolgen, dass unterschiedliche Bereiche auf dem Wafer mit unterschiedlichen Werten der Schwellwertspannung versehen werden, beispielsweise unterschiedlich für n-MOSFETs bzw. p-MOSFETs. Das Einbringen elektrischer Ladungsträger kann auch mittels eines Elektronenstrahls erfolgen. Die Mindestdicke von elektrisch isolierenden Schichten, beispielsweise Siliziumoxid-Schichten, von denen die Ladungsspeicherschicht vorzugsweise umgeben ist, beträgt ungefähr 10nm, damit die eingebrachten Ladungsträger ausreichend lange in der Ladungsspeicherschicht verbleiben.

Ausführungsbeispiele der Erfindung sind in den Figuren dargestellt und werden im Weiteren näher erläutert.

Es zeigen:
- Figur 1: eine Querschnittsansicht eines Substrats mit Halbleiterbereichen zweier Dicken gemäß dem Stand der Technik;
- Figur 2: eine Querschnittansicht eines erfindungsgemäßen Hilfsträgersubstrats, welches eine Schicht aus porösen Silizium und eine erste Halbleiterteilschicht aufweist;
- Figur 3: eine Querschnittsansicht des erfindungsgemäßen Hilfsträgersubstrats nach dem Aufbringen einer Schutzschicht und einer zweiten Halbleiterteilschicht;
- Figur 4: eine Querschnittsansicht des erfindungsgemäßen Hilfsträgersubstrats nach dem Abscheiden einer ersten Isolatorteilschicht und anschließender Planarisierung;
- Figur 5: eine Querschnittsansicht des erfindungsgemäßen Substrats, nach erfolgtem Bonden eines Trägersubstrats, welches eine Trägerschicht und eine zweite Isolatorteilschicht aufweist, auf das Hilfsträgersubstrat;
- Figur 6: eine Querschnittsansicht des erfindungsgemäßen Substrats nach Entfernen des Hilfsträgersubstrats;
- Figur 7: einen Feldeffekttransistor gemäß einem Aspekt der Erfindung,
- Figuren 8A: bis 8H Schichtenfolgen zu unterschiedlichen Zeitpunkten während eines Verfahrens zum Herstellen eines Feldeffekttransistors gemäß einem Aspekt der Erfindung,
- Figuren 9A,: 9B Schichtenfolgen zu unterschiedlichen Zeitpunkten während eines Verfahrens zum Herstellen Feldeffekttransistors gemäß einem anderen Aspekt der Erfindung.

Figur 2 zeigt ein Hilfsträgersubstrat 215, welches eine Hilfsträgerschicht 206 aus Silizium aufweist. Auf der Hilfsträgerschicht 206 aus Silizium ist eine Schicht 207 aus porösen Silizium aufgebracht. Auf der Schicht 207 aus porösen Silizium ist eine dünne erste Halbleiterteilschicht 208 aus Silizium aufgebracht. Die dünne erste Halbleiterteilschicht 208 weist eine Dicke im Bereich von 5 nm bis 30 nm auf. Vorzugsweise beträgt die Dicke der dünnen ersten Halbleiterschicht 208 20 nm.

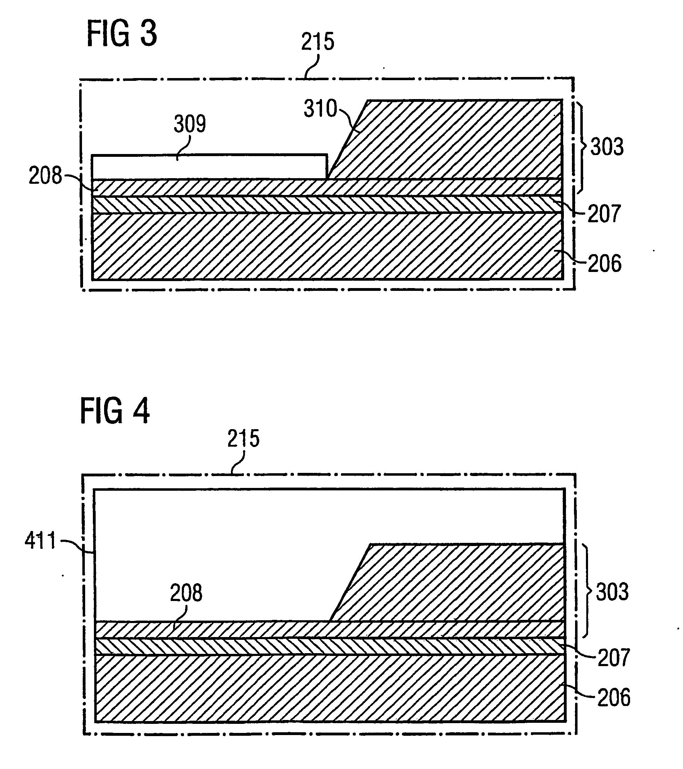

Figur 3 zeigt das Hilfsträgersubstrat 215 nach weiteren Verfahrenschritten, wobei auf der dünnen ersten Halbleiterteilschicht 208 eine Schutzschicht 309 aus Siliziumoxid aufgebracht ist. Diese Schutzschicht 309 wird mittels Rückätzens des Siliziumoxids in Teilbereichen des Hilfsträgersubstrats 215 in eine Maskierungsschicht umgeformt, d.h. strukturiert. In einem weiteren Prozessschritt wird nach Entfernen einer Lackschicht, welche für das Rückätzen aufgebracht wurde, in den Bereichen der dünnen ersten Halbleiterteilschicht 208, welche in Bereiche einer größeren Dicke 305 umgeformt werden sollen (die freiliegenden Bereiche, d.h. die Bereiche, die nicht von der strukturierten Maskierungsschicht bedeckt sind), mittels selektiver Epitaxie eine zweite Halbleiterteilschicht 310 ausgebildet. Die Gesamtdicke der zwei Halbleiterteilschichten 208 und 310 beträgt gemäß diesem Ausführungsbeispiel zusammen etwa 80 nm bis 120 nm, vorzugsweise 100 nm. Die beiden Halbleiterteilschichten 208 und 310 bilden die Halbleiterschicht 303 aus.

Figur 4 zeigt das Hilfsträgersubstrat 215 nach dem weiteren Prozessschritt des Abscheidens einer ersten Isolatorteilschicht 411 aus Siliziumoxid auf der gesamten Oberfläche des Hilfsträgersubstrats 215. Mittels des Abscheidens auf der gesamten Oberfläche des Hilfsträgersubstrats wird die Maskierungsschicht 309 ein integraler Teil der ersten Isolatorteilschicht 411. Eine Oberfläche der Isolatorteilschicht 411 wird mittels chemisch-mechanischen Polierens poliert und planarisiert.

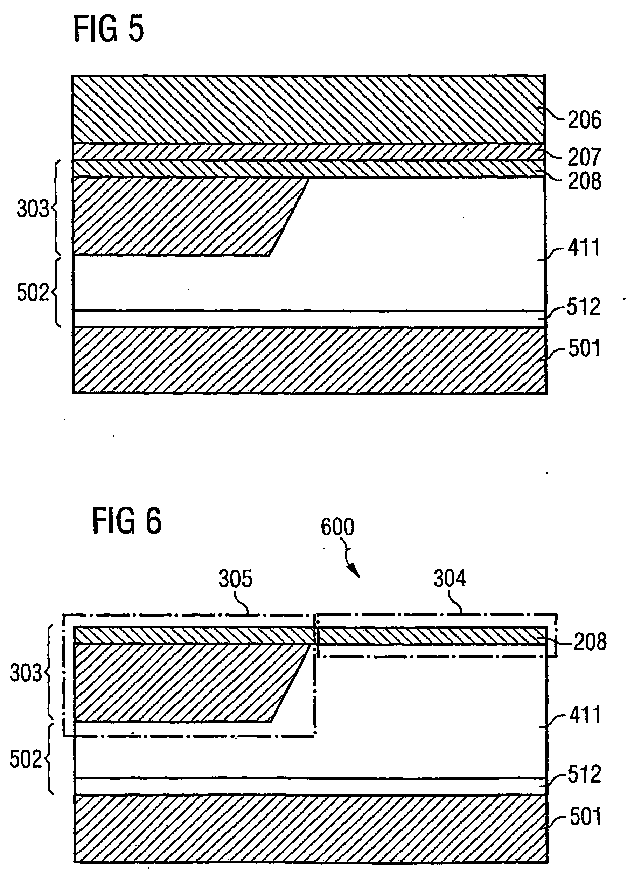

Figur 5 zeigt das Hilfsträgersubstrat 215 nachdem es mittels Wafer-Bondens auf ein Trägersubstrat 501 aufgebracht wurde. Hierzu wird das Hilfsträgersubstrat 215 umgedreht, d.h. das Hilfsträgersubstrat 215 wird bezüglich einer in Figur 4 senkrecht zur Papierebene gelegenen Achse um 180° gedreht, mit seiner planarisierten Oberfläche der ersten Isolatorteilschicht 411 auf das Trägersubstrat 501, auf welchem eine zweite Isolatorteilschicht 512 ausgebildet ist, aufgesetzt und gebunden. Durch das Bonden entsteht aus der ersten Isolatorteilschicht 411 und der zweiten Isolatorteilschicht 512 eine einstückige Isolatorschicht 502.

Ein mögliches Verfahren des Wafer-Bondens ist zum Beispiel das direkte, adhäsive Wafer-Bonden, bei diesem Verfahren wird auf ein Hilfswafer das eigentliche Siliziumwafer aufgebracht und adhäsiv gebondet. Ein weiteres Verfahren des Wafer-Bondens ist zum Beispiel das anodische (elektrostatische) Bonden, bei dem die zwei Substrate, mit welchen das Bonden durchgeführt werden soll, zusammengebracht und auf eine hohe Temperatur gebracht werden, während ein starkes elektrisches Feld über eine Verbindungsschicht zwischen den beiden Substraten hinweg angelegt wird. Hierdurch wird eine starke Bindung zwischen den beiden Substraten ausgebildet.

Figur 6 zeigt ein Substrat 600, nachdem die Hilfsträgerschicht 206 entfernt wurde. Erfindungsgemäß geschieht dies, indem die poröse Siliziumschicht 207 mittels eines Wasserstrahls geätzt wird. Hierdurch wird die Hilfsträgerschicht 206 entfernt und die Schichtenfolge des Substrats 600 ist fertig ausgebildet. Das erfindungsgemäße Substrat 600 weist nach den beschriebenen Verfahrensschritten

Nachfolgend wird das Substrat 600 unter Verwendung von H₂ getempert. Aus den Bereichen der Halbleiterschicht 303 geringer Dicke 304 werden mittels Diffusions-Dotierens bzw. Ionenimplantation von Elementen der dritten bzw. der fünften Hauptgruppe z.B. Bor, Phosphor oder Arsen Bereiche ausgebildet, welche vollständig an elektrischen Ladungsträgern verarmt sind, und aus den Bereichen der Halbleiterschicht 303 großer Dicke 305 werden mittels Diffusions-Dotierens bzw.

Ionenimplantation von Elementen der dritten bzw. der fünften Hauptgruppe z.B. Bor, Phosphor oder Arsen Bereiche ausgebildet, welche teilweise an Ladungsträgern verarmt sind.

Zusammenfassend schafft die Erfindung ein FD-PD-SOI-Mischsubstrat, welches eine ebene Oberfläche der Siliziumschicht aufweist, durch welche ebene Oberfläche ein weiteres Prozessieren vereinfacht wird.

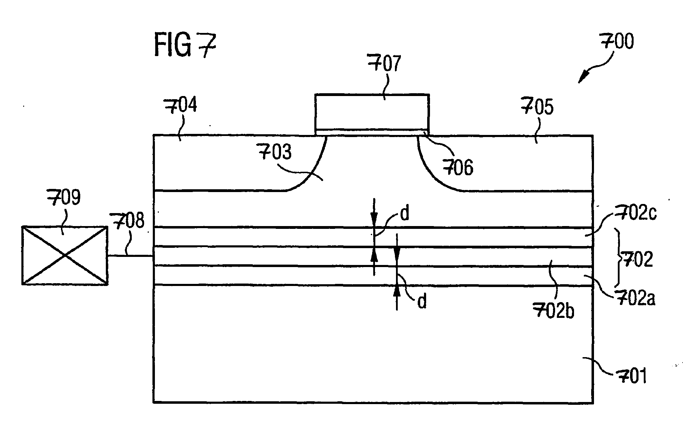

Im Weiteren wird bezugnehmend auf Fig.7 ein Feldeffekttransistor 700 gemäß einem Aspekt der Erfindung beschrieben.

Der in Fig.7 gezeigte Feldeffekttransistor 700 weist ein Silizium-Substrat 701 und eine Ladungsspeicher-Schichtenfolge 702 auf. Die Ladungsspeicher-Schichtenfolge 702 ist aus einer elektrisch isolierenden ersten Siliziumoxid-Schicht 702a, einer elektrisch leitfähigen Polysilizium-Schicht 702b auf der ersten Siliziumoxid-Schicht 702a und aus einer elektrisch isolierenden zweiten Siliziumoxid-Schicht 702c auf der Polysilizium-Schicht 702b aufgebaut. Oberhalb der Ladungsspeicher-Schichtenfolge 702 ist ein undotierter Kanal-Bereich 703 ausgebildet. Ferner weist der Feldeffekttransistor 700 einen ersten n⁺-dotierten Source-/Drain-Bereich 704 und einen zweiten n⁺-dotierten Source-/Drain-Bereich 705 auf. Über dem Kanal-Bereich 703 zwischen den beiden Source-/Drain-Bereichen 704, 705 ist eine Gate-isolierende Schicht 706 aus Siliziumoxid angeordnet. Auf der Gate-isolierenden Schicht 706 ist ein Gate-Bereich 707 angeordnet. Ferner ist die Polysilizium-Schicht 702b optional über einen Anschluss 708 mit einer regelbaren Spannungsquelle 709 gekoppelt.

Um die Schwellenspannung des Feldeffekttransistors 700 einzustellen, werden über die regelbare Spannungsquelle 709 und den Anschluss 708 in die Polysilizium-Schicht 702b Ladungsträger injiziert, die infolge der beidseitigen Ummantelung der Polysilizium-Schicht 702b mit elektrisch isolierenden Schichten 702a, 702c vor einem Abfließen in die Umgebung geschützt sind. Da die Dicke d der elektrisch isolierenden Schichten 702a, 702c mit 10nm ausreichend dick gewählt ist, sind die Ladungsträger in der Polysilizium-Schicht 702b vor einem Abfließen ausreichend sicher geschützt, sodass für eine ausreichend lange Haltezeit von beispielsweise zehn Jahren die Ladungsträger in der Polysilizium-Schicht 702b dauerhaft gespeichert sind. Nach Programmieren der Ladungsspeicher-Schichtenfolge 702 wird die regelbare Spannungsquelle 709 von dem Feldeffekttransistor 700 elektrisch entkoppelt. Aufgrund der in der Polysilizium-Schicht 702b dauerhaft gespeicherten Elektronen ist die elektrische Leitfähigkeit bzw. die elektrische Feldverteilung innerhalb des Kanal-Bereichs 703 charakteristisch modifiziert, sodass eine gewünschte Schwellenspannung eingestellt ist.

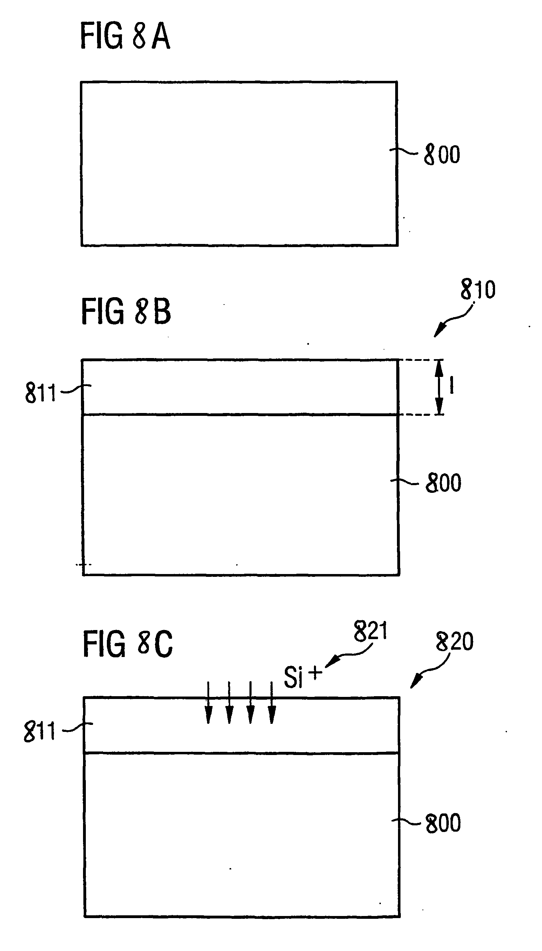

Im Weiteren wird bezugnehmend auf Fig.8A bis Fig.8H ein Verfahren zum Herstellen eines Feldeffekttransistors gemäß einem Aspekt der Erfindung beschrieben.

Als Ausgangsmaterial wird der in **Fig.8A** gezeigte Silizium-Wafer 800 aus einkristallinem Silizium verwendet.

Um die in **Fig.8B** gezeigte Schichtenfolge 810 zu erhalten, wird die gemäß Fig.8B obere Oberfläche des Silizium-Wafers 800 thermisch oxidiert, wodurch eine erste Siliziumoxid-Schicht 811 ausgebildet wird (die Rückseitenoxidation ist in der Figur nicht gezeigt). Gemäß dem beschriebenen Ausführungsbeispiel wird der Silizium-Wafer 800 derart oxidiert, dass die Dicke der ersten Siliziumoxid-Schicht 811 ungefähr 30nm ist.

Um die in **Fig.8C** gezeigte Schichtenfolge 820 zu erhalten, wird unter Verwendung eines geeigneten Ionenimplantations-Verfahrens Silizium-Material in der ersten Siliziumoxid-Schicht 811 implantiert. Dieses Silizium-Material wird in weiteren Verfahrensschritten dafür verwendet, eine Schicht aus nanokristallinen Silizium-Strukturen in der ersten Siliziumoxid-Schicht 811 auszubilden. Alternativ zu den in Fig.8C gezeigten Si⁺-Ionen 821 können zum Beispiel Germanium-Ionen (Ge⁺) in die erste Siliziumoxid-Schicht 811 eingebracht werden.

Die effektive Ionenimplantationsdosis von Silizium bzw. Germanium in der ersten Siliziumdioxid-Schicht 811 ist beispielsweise in der Größenordnung von 10¹⁵cm⁻².

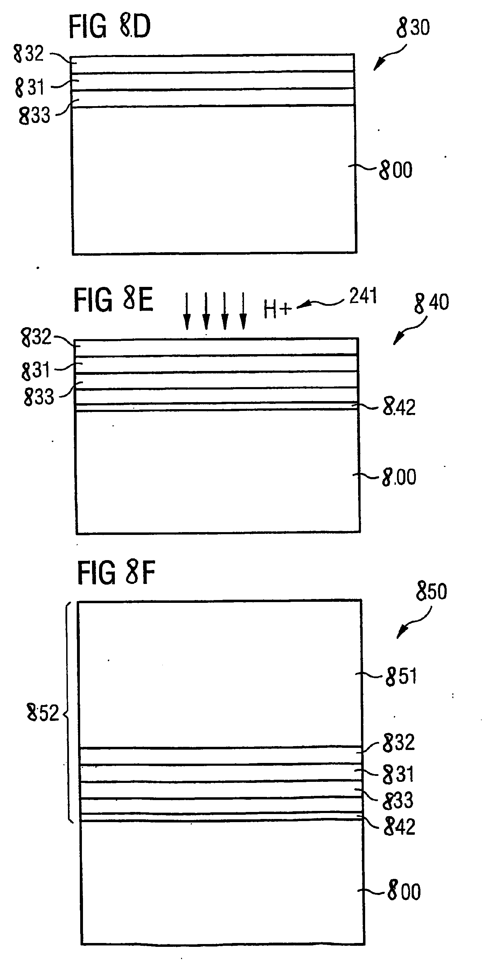

Um die in **Fig.8D** gezeigte Schichtenfolge 830 zu erhalten, wird die in Fig.8C gezeigte Schichtenfolge 820 einem Ausheil-Verfahren (Annealing) unterzogen, um aus den Silizium-Ionen 821 in der ersten Siliziumoxid-Schicht 811 Nanokristalle zu generieren. Dadurch entsteht eine Silizium-Nanokristallschicht 831 zwischen einer ersten Siliziumoxid-Teilschicht 832 und einer zweiten Siliziumoxid-Teilschicht 833.

Die lineare Dimension der nanokristallinen Silizium- bzw. Germanium-Strukturen sind zwischen ungefähr 1nm und ungefähr 10nm. Der Abstand benachbarter Nanokristalle voneinander ist vorzugsweise mindestens 5nm.

Um die in **Fig.8E** gezeigte Schichtenfolge 840 zu erhalten, werden Wasserstoff-Ionen H⁺ 841 (optional können zum Beispiel auch Bor-Ionen verwendet werden) in das Silizium-Substrat 800 unterhalb der zweiten Siliziumoxid-Teilschicht 833 eingebracht, sodass dadurch eine Ablöseschicht 842 ausgebildet wird. Die Ablöseschicht ist Silizium-Material, in dem Wasserstoff-Ionen 841 akkumuliert sind, sodass diese Schicht mechanisch destabilisiert ist. Der Bereich zwischen der Ablöseschicht 842 und der zweiten Siliziumoxid-Teilschicht 833 kann ebenfalls eine gewisse Menge Wasserstoff-Ionen enthalten, jedoch weniger als eine kritische Konzentration, die für ein Ablösen überschritten werden muss.

Um die in **Fig.8F** gezeigte Schichtenfolge 850 zu erhalten, wird ein anderer Silizium-Wafer 851 unter Verwendung eines Wafer-Bonding Verfahrens derart mit der Schichtenfolge 840 befestigt, dass eine Unterseite des anderen Silizium-Wafers 851 an die erste Siliziumoxid-Teilschicht 832 angrenzt und mit dieser befestigt ist. Dadurch ist eine Schichtenfolge 850 geschaffen, die aus einer Nutz-Schichtenfolge 852 und einem Teilbereich des Silizium-Substrats 800 aufgebaut ist, die voneinander durch die Ablöseschicht 842 getrennt sind.

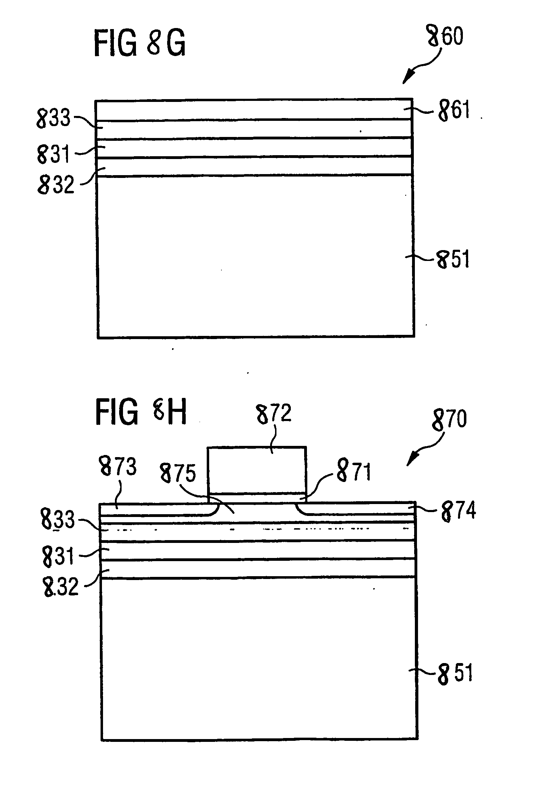

Um die in **Fig.8G** gezeigte Schichtenfolge 860 zu erhalten, wird die Nutz-Schichtenfolge 852 von der Schichtenfolge 850 an der mechanisch destabilisierten Ablöseschicht 842 abgelöst. Die Schichtenfolge 860 zeigt die um 180° gedrehte Nutzschichtenfolge 852 nach dem Ablösen. Insbesondere ist ein Dünnschicht-Silizium-Bereich 861 in einem Oberflächenbereich der Schichtenfolge 860 geschaffen, der das kristalline Ausgangsmaterial für eine folgende CMOS-Prozessierung darstellt.

Um den in **Fig.8H** gezeigten Feldeffekteffekttransistor 870 zu erhalten, wird zunächst eine weitere Siliziumoxid-Schicht thermisch gewachsen und eine Polysilizium-Schicht auf der Oberfläche der Schichtenfolge 860 abgeschieden. Diese beiden Schichten werden derart strukturiert, dass dadurch eine Gate-isolierende Schicht 871 und ein Gate-Bereich 872 zurückbleiben. Unter Verwendung eines geeigneten Implantationsverfahrens werden ein erster n⁺-dotierter Source-/Drain-Bereich 873 und ein zweiter n⁺-dotierter Source-/Drain-Bereich 874 ausgebildet. Zwischen den Source-/Drain-Bereichen 873, 874 bleibt ein Kanal-Bereich 875 zurück. Dadurch ist der in Fig.8H gezeigte Feldeffekttransistor 870 mit einstellbaren Transistoreigenschaften geschaffen.

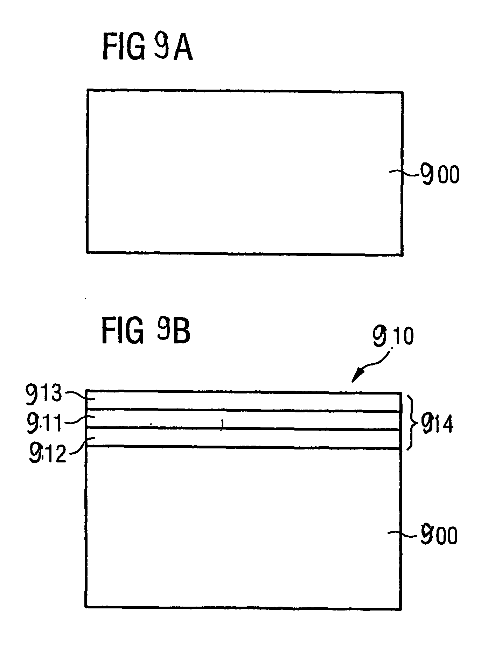

Im Weiteren wird bezugnehmend auf Fig.9A, Fig.9B ein Verfahren zum Herstellen eines Feldeffekttransistors gemäß einem anderen Aspekt der Erfindung beschrieben.

Ausgangsmaterial ist wiederum ein Silizium-Wafer 900, wie er in **Fig.9A** gezeigt ist.

Um die in **Fig.9B** gezeigte Schichtenfolge 910 zu erhalten, wird der gemäß Fig.9A obere Oberflächenbereich des Silizium-Wafers 900 thermisch oxidiert und dadurch eine Siliziumoxid-Schicht ausgebildet. Mittels Nitridierens wird eine Siliziumnitrid-Schicht 911 oberhalb einer ersten Siliziumoxid-Teilschicht 912 ausgebildet. Mittels thermischen Oxidierens der erhaltenden Schichtenfolge wird eine zweite Siliziumoxid-Teilschicht 913 ausgebildet. Dadurch ist eine ONO-Schichtenfolge 914 an einem Oberflächenbereich der Schichtenfolge 910 geschaffen, die als Ladungsspeicherschicht verwendbar ist.

Die in Fig.9B gezeigte Schichtenfolge 910 ähnelt funktionell der in Fig.8D gezeigten Schichtenfolge 830. Daher können die weiteren Verfahrensschritte zum Ausbilden eines Feldeffekttransistors ausgehend von der Schichtenfolge 910 analog erfolgen, wie bezugnehmend auf Fig.8E bis Fig.8H beschrieben ist. Der Unterschied eines derartig ausgebildeten Feldeffekttransistors zu dem in Fig.8H gezeigten Feldeffekttransistor 870 besteht darin, dass bei dem ausgehend von der Schichtenfolge 910 hergestellten Feldeffekttransistor als Ladungsspeicherschicht eine ONO-Schichtenfolge verwendet wird, wohingegen bei dem Feldeffekttransistor 870 eine Polysilizium-Schicht 831, eingebettet zwischen zwei Siliziumoxid-Teilschichten 832, 833 verwendet wird.

In diesem Dokument sind folgende Veröffentlichungen zitiert:
[1] Eitan, B, Pavan, P, Bloom, I, Aloni, E, Frommer, A, Finzi, D (2000) "NROM: A Novel Localized Trapping, 2-Bit Nonvolatile Memory Cell" IEEE Electron Device Letters 21(11):543-545
[2] Hanafi, HI, Tiwari, S, Khan, I (1996) "Fast and Long Retention-Time Nano-Crystal Memory" IEEE Transaction on Electron Devices 43(9):1553-1558
[3] Widmann, D, Mader, H, Friedrich, H (1996) "Technologie hochintegrierter Schaltungen", Kapitel 8.4, Springer Verlag, Berlin, IBSN 3-540-59357-8
[4] Homepage Firma Soitec (12. Februar 2002): http://www.soitec.com/unibond.htm
[5] JP 2000 306 993 A
[6] JP 06 110 4412 A
[7] JP 04 323 851 A
[8] US 6, 329, 689 B1

### Bezugszeichenliste

- 100: SOI-Substrat
- 101: Siliziumträgersubstrat
- 102: Siliziumoxidschicht
- 103: Siliziumhalbleiterschicht
- 104: FD-Bereich
- 105: PD-Bereich
- 206: Hilfsträgerschicht
- 207: Schicht aus porösen Silizium
- 208: dünne erste Halbleiterteilschicht
- 215: Hilfsträgersubstrat
- 303: Halbleiterschicht
- 304: FD-Bereich
- 305: PD-Bereich
- 309: Schutzschicht aus Siliziumoxid
- 310: zweite Halbleiterteilschicht
- 411: erste Isolatorteilschicht
- 501: Trägersubstrat
- 502: Isolatorschicht
- 512: zweite Isolatorteilschicht
- 600: SOI Substrat
- 700: Feldeffekttransistor
- 701: Silizium-Substrat
- 702: Ladungsspeicher-Schichtenfolge
- 702a: erste Siliziumoxid-Schicht
- 702b: Polysilizium-Schicht
- 702c: zweite Siliziumoxid-Schicht
- 703: Kanal-Bereich
- 704: erster Source-/Drain-Bereich
- 705: zweiter Source-/Drain-Bereich
- 706: Gate-isolierende Schicht
- 707: Gate-Bereich
- 708: Anschluss
- 709: regelbare Spannungsquelle
- 800: Silizium-Wafer
- 810: Schichtenfolge
- 811: erste Siliziumoxid-Schicht
- 820: Schichtenfolge
- 821: Si⁺-Ionen
- 830: Schichtenfolge
- 831: Silizium-Nanokristallschicht
- 832: erste Siliziumoxid-Teilschicht
- 833: zweite Siliziumoxid-Teilschicht
- 840: Schichtenfolge
- 841: H⁺-Ionen
- 842: Ablöse-Schicht
- 850: Schichtenfolge
- 851: anderer Silizium-Wafer
- 852: Nutz-Schichtenfolge
- 860: Schichtenfolge
- 861: Dünnschicht-Silizium-Bereich
- 870: Feldeffekttransistor
- 871: Gate-isolierende Schicht
- 872: Gate-Bereich
- 873: erster Source-/Drain-Bereich
- 874: zweiter Source-/Drain-Bereich
- 875: Kanal-Bereich
- 900: Silizium-Wafer
- 910: Schichtenfolge
- 911: Siliziumnitrid-Schicht
- 912: erste Siliziumoxid-Teilschicht
- 913: zweite Siliziumoxid-Teilschicht
- 914: ONO-Schichtenfolge

## Patentansprüche

1. Substrat (600), welches aufweist:
eine Trägerschicht (501);
eine auf der Trägerschicht (501) aufgebrachte Isolatorschicht (502), welche mindestens zwei Bereiche mit jeweils unterschiedlicher Dicke aufweist, so dass eine gestufte Oberfläche der Isolatorschicht (502) ausgebildet ist;
eine auf die gestufte Oberfläche der Isolatorschicht (502) aufgebrachte Halbleiterschicht (303), welche Halbleiterschicht (303) eine planare Oberfläche aufweist, wobei die planare Oberfläche die Oberfläche ist, welche der gestuften Oberfläche der Isolatorschicht (502) entgegengesetzt ist; Transistoren, die auf der Halbleiterschicht (303) ausgebildet sind;
wobei das Substrat aus einem ersten Teilsubstrat und einem zweiten Teilsubstrat besteht, welche mittels Bonden miteinander verbunden sind;
**dadurch gekennzeichnet,**
**daß** die Halbleiterschicht (303) zumindest teilweise epitaktisch gebildet ist, und
**dass** die Bereiche der Halbleiterschicht (303) zweier verschiedener Dicken (304, 305) teilweise an Ladungsträgern verarmt sind bzw. vollständig an Ladungsträgern verarmt sind, so dass Transistoren mit unterschiedlichen elektrischen Transistoreigenschaften in den jeweiligen Bereichen der Halbleiterschichten ausgebildet sind.

2. Substrat gemäß Anspruch 1, wobei die Halbleiterschicht (303) Silizium aufweist.

3. Substrat gemäß Anspruch 1 oder 2, wobei die Isolatorschicht (502) aus Siliziumoxid gebildet wird.

4. Verfahren zum Herstellen eines Substrats, welches folgende Schritte aufweist :
Aufbringen einer Isolatorschicht (502) zweier verschiedener Dicken auf einer ersten Trägerschicht (501), derart dass eine gestufte Oberfläche der Isolatorschicht (502) ausgebildet wird;
Aufbringen einer Halbleiterschicht (303) auf der gestuften Oberfläche der Isolatorschicht (502) derart, dass eine planare Oberfläche der Halbleiterschicht (303) ausgebildet wird, welche planare Oberfläche der gestuften Oberfläche der Isolatorschicht (502) entgegengesetzt ist:
Ausbilden von Transistoren auf der Halbleiterschicht (303);
wobei das Substrat aus einem ersten Teilsubstrat und einem zweiten Teilsubstrat bestehend gebildet wird, welche mittels Bonden miteinander verbunden werden.;
**dadurch gekennzeichnet, dass**
die Halbleiterschicht (303) zumindest teilweise epitaktisch aufgebracht wird;
zum Bilden der Halbleiterschicht eine dünne erste Halbleiterschicht (208) auf einer Hilfsträgerschicht (206) eines ersten Teilsubstrats ausgebildet wird;
eine Maskierungsschicht (309) aus einem Isolatormaterial auf mindestens einem Bereich der dünnen ersten Halbleiterteilschicht (208) abgeschieden wird;
zum Bilden der Halbleiterschicht eine zweite Halbleiterschicht (310) in den Bereichen der dünnen ersten Halbleiterteilschicht (308) ausgebildet wird, welche nicht durch die Maskierungsschicht (309) aus dem Isolatormaterial bedeckt sind;
zum Bilden der Isolatorschicht eine erste Isolatorteilschicht (411) auf der gesamten Substratoberfläche abgeschieden wird und anschließend die erste Isolatorteilschicht (411) planarisiert wird;
ein zweites Teilsubstrat gebondet wird, welches auf einer Trägerschicht (501) eine zweite Isolatorteilschicht (512) aufweist, auf die planarisierte Oberfläche der ersten Isolatorteilschicht (411); und
die Hilfsträgerschicht (206) entfernt wird.

5. Verfahren gemäß Anspruch 4, wobei das Planarisieren der ersten Isolatorteilschicht mittels chemisch-mechanischen Polierens ausgeführt wird.

6. Verfahren gemäß einem der Ansprüche 4 oder 5, wobei auf der Hilfsträgerschicht vor Aufbringen der dünnen ersten Halbleiterteilschicht eine Schicht aus porösen Silizium erzeugt wird.

7. Verfahren gemäß Anspruch 6, wobei das poröse Silizium zum Entfernen der Hilfsträgerschicht mittels Ätzens mittels eines Wasserstrahles entfernt wird.

8. Verfahren gemäß einem der Ansprüche 4 bis 7, wobei das Verfahren ferner nach dem Entfernen der Hilfsträgerschicht den Schritt einer H2 Temperung des Substrates aufweist.

9. Verfahren gemäß einem der Ansprüche 4 bis 8, wobei die Trägerschicht, die Hilfsträgerschicht, die dünne erste Halbleiterteilschicht und die zweite Halbleiterteilschicht im Wesentlichen Silizium aufweisen.

10. Verfahren gemäß einem der Ansprüche 4 bis 9, wobei die erste Isolatorschicht, die zweite Isolatorschicht und die Schutzschicht im Wesentlichen Siliziumoxid aufweisen.

11. Verfahren gemäß einem der Ansprüche 4 bis 10, wobei die dünne erste Halbleiterteilschicht und/oder die zweite Halbleiterteilschicht mittels Epitaxie und/oder selektiver Epitaxie ausgebildet werden.

12. Verfahren gemäß einem der Ansprüche 4 bis 11, wobei aus dem Bereich der Halbleiterschicht, welcher eine größere Dicke aufweist, mittels Dotierens ein Bereich erzeugt wird, welcher teilweise an Ladungsträgern verarmt ist und wobei aus dem Bereich der Halbleiterschicht, welcher eine kleinere Dicke aufweist, mittels Dotierens ein Bereich erzeugt wird, welcher vollständig an Ladungsträgern verarmt ist.

## Claims

1. A substrate (600) having:
a carrier layer (501);
an insulator layer (502), which is applied on the carrier layer (501) and has at least two regions each having a different thickness, thereby forming a stepped surface of the insulator layer (502);
a semiconductor layer (303), which is applied to the stepped surface of the insulator layer (502), which semiconductor layer (303) has a planar surface, the planar surface being the surface which is opposite to the stepped surface of the insulator layer (502); transistors formed on the semiconductor layer (303); the substrate comprising a first partial substrate and a second partial substrate, which are connected to one another by means of bonding;
**characterized by**:
the semiconductor layer (303) being formed at least partially epitaxially; and
the regions of the semiconductor layer (303) of two different thicknesses (304, 305) being partially depleted of charge carriers and, respectively, being fully depleted of charge carriers, thereby forming transistors in the respective regions of the semiconductor layers having different electrical transistor characteristics.

2. The substrate as claimed in claim 1, the semiconductor layer (303) comprising silicon.

3. The substrate as claimed in claim 1 or 2, the insulator layer (502) being formed from silicon oxide.

4. A method for producing a substrate, having the following steps:
applying an insulator layer (502) of two different thicknesses on a first carrier layer (501) in such a way that a stepped surface of the insulator layer (502) is formed;
applying a semiconductor layer (303) on the stepped surface of the insulator layer (502) in such a way that a planar surface of the semiconductor layer (303) is formed, which planar surface is opposite to the stepped surface of the insulator layer (502);
forming transistors on the semiconductor layer (303); the substrate comprising a first partial substrate and a second partial substrate, which are connected to one another by means of bonding;
**characterized by**:
applying the semiconductor layer (303) at least partially epitaxial;
in order to form the semiconductor layer, forming a thin first semiconductor partial layer (208) on an auxiliary carrier layer (206) of a first partial substrate;
depositing a masking layer (309) made of an insulator material on at least one region of the thin first semiconductor partial layer (208);
in order to form the semiconductor layer, forming a second semiconductor partial layer (310) in the regions of the thin first semiconductor partial layer (308) which are not covered by the masking layer (309) made of the insulator material;
in order to form the insulator layer, depositing a first insulator partial layer (411) on the entire substrate surface and subsequently planarizing the first insulator partial layer (411);
bonding a second partial substrate, having a second insulator partial layer (512) on a carrier layer (501), onto the planarized surface of the first insulator partial layer (411); and
removing the auxiliary carrier layer (206).

5. The method as claimed in claim 4, the planarization of the first insulator partial layer being performed by means of chemical mechanical polishing.

6. The method as claimed in claim 4 or 5, a layer made of porous silicon being produced on the auxiliary carrier layer before the application of the thin first semiconductor partial layer.

7. The method as claimed in claim 6, the porous silicon being removed by means of a water jet for the purpose of removing the auxiliary carrier layer by means of etching.

8. The method as claimed in one of claims 4 to 7, the method further having the step of an H2 heat treatment of the substrate after the removal of the auxiliary carrier layer.

9. The method as claimed in one of claims 4 to 8, the carrier layer, the auxiliary carrier layer, the thin first semiconductor partial layer and the second semiconductor partial layer essentially comprising silicon.

10. The method as claimed in one of claims 4 to 9, the first insulator layer, the second insulator layer and the protective layer essentially comprising silicon oxide.

11. The method as claimed in one of claims 4 to 10, the thin first semiconductor partial layer and/or the second semiconductor partial layer being formed by means of epitaxy and/or selective epitaxy.

12. The method as claimed in one of claims 4 to 11, a region which is partially depleted of charge carriers being produced by means of doping that region of the semiconductor layer which has a larger thickness, and a region which is fully depleted of charge carriers being produced by means of doping that region of the semiconductor layer which has a smaller thickness.

## Revendications

1. Substrat (600) qui comporte :
une couche (501) de support;
une couche (502) isolante déposée sur la couche (501) de support, et ayant au moins deux parties d'épaisseur différentes de manière à former une surface étagée de la couche (502) isolante ;
une couche (303) semi-conductrice disposée sur la surface étagée de la couche (502) isolante, cette couche (303) semi-conductrice ayant une surface planaire, la surface planaire étant la surface qui est opposée à la surface étagée de la couche (502) isolante ;
des transistors qui sont formés sur la couche (303) semi-conductrice ;
dans lequel le substrat est constitué d'un premier substrat partiel et d'une deuxième substrat partiel qui sont reliés entre eux au moyen de liaisons ;
**caractérisé en ce que**
la couche (303) semi-conductrice est formée, au moins en partie, par épitaxie, et
**en ce que** les parties de la couche (303) semi-conductrice de deux épaisseurs (304, 305) différentes sont appauvries en partie en porteurs de charge ou sont appauvries complètement en porteurs de charge de manière à former des transistors ayant des propriétés électriques de transistor différentes dans les parties respectives des couches semi-conductrices.

2. Substrat suivant la revendication 1, dans lequel la couche (303) semi-conductrice comporte du silicium.

3. Substrat suivant la revendication 1 ou 2, dans lequel la couche (502) isolante est en oxyde de silicium.

4. Procédé de production d'un substrat qui a les stades suivants :
on dépose une couche (502) isolante de deux épaisseurs différentes sur une première couche (501) de support de manière à former une surface étagée de la couche (502) isolante ;
on dépose une couche (303) semi-conductrice sur la surface étagée de la couche (502) isolante de manière à former une surface planaire de la couche (303) semi-conductrice, cette surface planaire étant opposée à la surface étagée de la couche (502) isolante ;
on forme des transistors sur la couche (303) semi-conductrice ;
dans lequel le substrat est formé d'un premier substrat partiel et d'un deuxième substrat partiel qui sont reliés entre eux au moyen de liaisons ;
**caractérisé en ce que**
on dépose la couche (303) semi-conductrice au moins en partie par épitaxie ;
pour former la couche semi-conductrice, on forme une mince première couche (208) semi-conductrice sur une couche (206) auxiliaire de support d'un premier substrat partiel ;
on dépose une couche (309) de masquage en un matériau isolant sur au moins une partie de la première couche (208) partielle mince semi-conductrice ;
pour former la couche semi-conductrice, on forme une deuxième couche (310) semi-conductrice dans les parties de la première couche (308) mince partielle semi-conductrice, qui ne sont pas revêtues par la couche (309) de masquage en le matériau isolant ;
pour former la couche isolante, on dépose une première couche (411) partielle isolante sur toute la surface du substrat et on planarise ensuite la première couche (411) partielle isolante ;
on relie un deuxième substrat partiel qui a, sur une couche (501) de support, une deuxième couche (512) partielle isolante, à la surface planarisée de la première couche (411) partielle isolante ; et
on élimine la couche (206) auxiliaire de support.

5. Procédé suivant la revendication 4, dans lequel on effectue la planarisation de la première couche partielle isolante au moyen d'un polissage semi-mécanique.

6. Procédé suivant les revendications 4 ou 5, dans lequel on produit une couche en silicium poreux sur la couche auxiliaire de support avant le dépôt de la première couche partielle mince semi-conductrice.

7. Procédé suivant la revendication 6, dans lequel on élimine le silicium poreux pour éliminer la couche auxiliaire de support au moyen d'une attaque par un jet d'eau.

8. Procédé suivant l'une des revendications 4 à 7, dans lequel le procédé comporte en outre, après l'élimination de la couche auxiliaire de support, le stade d'un recuit H2 du substrat.

9. Procédé suivant l'une des revendications 4 à 8, dans lequel la couche de support, la couche auxiliaire de support, la première couche partielle mince semi-conductrice et la deuxième couche partielle semi-conductrice comportent essentiellement du silicium.

10. Procédé suivant l'une des revendications 4 à 9, dans lequel la première couche isolante, la deuxième couche isolante et la couche de protection comportent essentiellement de l'oxyde de silicium.

11. Procédé suivant l'une des revendications 4 à 10, dans lequel la première couche partielle mince semi-conductrice et/ou la deuxième couche semi-conductrice sont constituées au moyen d'une épitaxie et/ou d'une épitaxie sélective.

12. Procédé suivant l'une des revendications 4 à 11, dans lequel on produit, à partir de la partie de la couche semi-conductrice qui a une épaisseur plus grande, à l'aide d'un dopage, une partie qui est appauvrie en partie en porteurs de charge et dans lequel on produit, à partir de la partie de la couche semi-conductrice qui a une épaisseur plus petite, à l'aide d'un dopage, une partie qui est appauvrie complètement en porteurs de charge.
